# EUROPEAN PATENT SPECIFICATION

(11) **EP 4 304 044 B1**
(45) Date of publication and mention of the grant of the patent: **31.12.2025**
(21) Application number: 22890381.1
(22) Date of filing: 02.11.2022
(51) Int. Cl.: H02J 7/00, G01R 19/165, G01R 31/382, H02J 7/34

(54) **POWER STORAGE SOURCE MANAGEMENT APPARATUS AND METHOD FOR CONTROLLING THE SAME**
VORRICHTUNG ZUR VERWALTUNG EINER STROMSPEICHERQUELLE UND STEUERUNGSVERFAHREN DAFÜR
APPAREIL DE GESTION DE SOURCE DE STOCKAGE D'ÉNERGIE ET SON PROCÉDÉ DE COMMANDE

(30) Priority: 02.11.2021 KR 20210149215
(43) Date of publication of application: 10.01.2024
(60) Divisional application: 25210464.1
(73) Proprietor: LG ENERGY SOLUTION, LTD., Seoul 07335 (KR)
(72) Inventor: SHIN, Chae-Bin, Daejeon 34122 (KR); KIM, Dong-Joo, Daejeon 34122 (KR); KIM, Seung-Hyun, Daejeon 34122 (KR); KIM, An-Soo, Daejeon 34122 (KR); LEE, Hyun-Chul, Daejeon 34122 (KR)
(74) Representative: Plasseraud IP
(86) International application number: PCT/KR2022/017072
(87) International publication number: WO 2023/080650

(56) References cited:
- WO-A1-2020/160369
- WO-A2-2012/097349
- JP-A- 2006 174 535
- KR-A- 20130 031 203
- KR-B1- 102 063 692
- KR-B1- 102 084 676
- US-A1- 2014 094 985
- US-A1- 2021 197 690

## Description

### TECHNICAL FIELD

The present disclosure relates to a power storage source management apparatus and a method for controlling the same, and more particularly, to a power storage source management apparatus for preventing the power storage source being charged or discharged from stopping charging/discharging in the latter stage of charging or discharging and a method for controlling the same.

### BACKGROUND ART

Recently, the global resource depletion and serious climate change lead to the growing interest in energy, and smart grid and renewable energy technology is attracting attention. Since renewable energy has a fluctuating energy supply disadvantage, there is need for technology to deal with the disadvantage.

An Energy Storage System (ESS) is used to overcome the disadvantage of renewable energy and build a smart grid more efficiently.

The ESS is a system that stores power produced through renewable energy or unused or excess power of the power grid in a power storage source and supplies the power grid with the stored power at times when power is needed in order to increase the power usage efficiency.

The ESS includes the power storage source including a plurality of batteries, a Power Conversion System (PCS) and an Energy Management System (EMS).

The PCS converts the characteristics of the electric current to output the power stored in the power storage source to the grid, and performs monitor-control, independent operation and grid protection functions. The EMS manages the entire ESS, and in particular, plays a role in adjusting the charging condition and the discharging condition of the power storage source to operate the ESS more efficiently.

The PCS charges the power storage source using power supplied from the power grid or renewable energy generator according to the operation policy set by the EMS. Additionally, the PCS provides power to the power grid by discharging the power storage source according to the operation policy set by the EMS.

The PCS has controllable power specifications. For example, when the power specification of the PCS is 5000 kW, the PCS may supply the charge power of up to 5000 kW to the power storage source or may be supplied with the discharge power of up to 5000 kw from the power storage source.

The PCS monitors the voltage and current of the power line to prevent the charge power and the discharge power of the power storage source from exceeding the controllable power specifications. A voltage measurement sensor and a current measurement sensor included in the PCS have a measurement error. In case in which the voltage measurement sensor and the current measurement sensor have an error of 1% or less, when the charge power and the discharge power is low, the power control accuracy of the PCS may be lowered. In the above example, the power corresponding to the error of 1% is 50 kW. Accordingly, when the charge power and the discharge power is equal to or less than 50 kW, the power control accuracy of the PCS may be lowered. Hereinafter, the power specification range, in which the power control accuracy of the PCS is low, is defined as an unstable power range.

The power storage source has a management apparatus. The management apparatus determines the allowable operating power limit of the power storage source according to a state of charge (SOC) and temperature of the power storage source. The operating power limit is the maximum allowable charge or discharge power of the power storage source. When the charge power inputted to the power storage source or the discharge power outputted from the power storage source is larger than the operating power limit in a predetermined percentage, the power storage source management apparatus stops charging/discharging of the power storage source in view of safety. For example, when being 10 to 20% larger than the operating power limit is set as the charge/discharge stop condition, the management apparatus immediately stops charging/discharging of the power storage source when the charge power or discharge power of the power storage source is 10 to 20% larger than the operating power limit.

The power range in which the power control accuracy of the PCS is low is the time when the SOC of the power storage source is close to the full charge state or full discharge state. As the SOC of the power storage source is closer to the full charge state or full discharge state, the charge power or discharge power decreases, and eventually, below the unstable power range of the PCS.

As mentioned above, in the unstable power range, the power control accuracy of the PCS is low. That is, it is difficult to accurately control the charge power and the discharge power at the level required by the power storage source management apparatus. Accordingly, the charge/discharge stop events occur frequently in the unstable power range. That is, on frequent occasions, the charge power supplied to the power storage source or the discharge power outputted from the power storage source may become larger than the operating power limit in a predetermined percentage. By this reason, in some instances, the power storage source is not fully charged or discharged and suddenly stops working.

### DISCLOSURE

### Technical Problem

The present disclosure is designed under the above-described background, and therefore the present disclosure is directed to providing a power storage source management apparatus with improved control logic to prevent a power storage source from suddenly stopping operation when the charge power or discharge power of the power storage source is lower than an unstable power range of a power conversion system and a method for controlling the same.

### Technical Solution

To solve the above-described technical problem, a power storage source management apparatus according to an aspect of the present disclosure includes a sensor unit configured to measure operational characteristics of a power storage source; and a control unit operably coupled to the sensor unit.

Preferably, the control unit may be configured to (i) acquire operational characteristics information of the power storage source from the sensor unit and determine an operating power limit of the power storage source, (ii) determine a charge power supplied from a Power Conversion System (PCS) or a discharge power provided to the PCS using the operational characteristics information during operation of the power storage source, (iii) stop the operation of the power storage source in response to a first operation stop condition being met in which the charge power or discharge power is larger than a preset unstable power range of the PCS, and the charge power or discharge power is larger than the operating power limit by a first threshold, and (iv) stop the operation of the power storage source in response to a second operation stop condition being met in which the charge power or discharge power is within the preset unstable power range of the PCS, and the charge power or discharge power is larger than the operating power limit by a second threshold (larger than the first threshold).

According to an aspect, the control unit may be configured to receive the operational characteristics information including a charge/discharge current, voltage and temperature of the power storage source from the sensor unit, determine a state of charge (SOC) of the power storage source by accumulating the charge/discharge current, and determine the operating power limit of the power storage source corresponding to the determined SOC and the received temperature by referring to lookup information defining a correlation between the SOC and temperature and the operating power limit.

According to another aspect, the control unit may receive information associated with the preset unstable power range of the PCS from the PCS.

Preferably, the first threshold may be 10% to 30% of the operating power limit. Additionally, the second threshold may be 30% to 60% of the operating power limit.

Optionally, the second threshold may increase as the charge power or discharge power of the power storage source decreases.

According to still another aspect, the power storage source may include first to n-th battery racks.

To solve the above-described technical problem, a power storage source management apparatus according to another aspect of the present disclosure includes first to n-th slave control units respectively mounted in first to n-th battery racks; and a master control unit coupled to the first to n-th slave control units to enable communication therebetween.

Preferably, each of the first to n-th slave control units may be configured to acquire operational characteristics information of the battery rack on its own mounted from a sensor unit, determine an operating power limit and a charge or discharge power of the battery rack using the operational characteristics information and provide the same to the master control unit.

Preferably, the master control unit may be configured to determine a total operating power limit and a total charge or discharge power by summing the operating power limits and the charge or discharge power transmitted from the first to n-th slave control units, provide an operation stop message to the first to n-th slave control units in response to a first operation stop condition being met in which the total charge or discharge power is larger than a preset unstable power range of a PCS and the total charge or discharge power is larger than the total operating power limit by a first threshold, and provide the operation stop message to the first to n-th slave control units in response to a second operation stop condition being met in which the total charge or discharge power is within the preset unstable power range of the PCS and the total charge or discharge power is larger than the total operating power limit by a second threshold (larger than the first threshold).

To solve the above-described technical problem, a method for controlling a power storage source management apparatus according to still another aspect of the present disclosure includes acquiring operational characteristics information of a power storage source from a sensor unit which measures operational characteristics of the power storage source; determining an operating power limit of the power storage source using the operational characteristics information; determining a charge power supplied from a PCS or a discharge power provided to the PCS using the operational characteristics information during operation of the power storage source; stopping the operation of the power storage source in response to a first operation stop condition being met in which the charge or discharge power is larger than a preset unstable power range of the PCS, and the charge or discharge power is larger than the operating power limit by a first threshold; and stopping the operation of the power storage source in response to a second operation stop condition being met in which the charge power or discharge power is within the preset unstable power range of the PCS, and the charge power or discharge power is larger than the operating power limit by a second threshold (larger than the first threshold).

To solve the above-described technical problem, a method for controlling a power storage energy management apparatus according to yet another aspect of the present disclosure is a method for controlling a power storage source management apparatus including first to n-th slave control units respectively mounted in first to n-th battery racks and a master control unit coupled to the first to n-th slave control units to enable communication therebetween, and includes acquiring, by each of the first to n-th slave control units, operational characteristics information from a sensor unit which measures operational characteristics of the battery rack on its own mounted, determining an operating power limit and a charge or discharge power of the battery rack and providing the same to the master control unit; determining, by the master control unit, a total operating power limit and a total charge or discharge power by summing the operating power limits and the charge or discharge power transmitted from the first to n-th slave control units; providing, by the master control unit, an operation stop message to the first to n-th slave control units in response to a first operation stop condition being met in which the total charge or discharge power is larger than a preset unstable power range of the PCS, and the total charge or discharge power is larger than the total operating power limit by a first threshold; providing, by the master control unit, the operation stop message to the first to n-th slave control units in response to a second operation stop condition being met in which the total charge or discharge power is within the preset unstable power range of the PCS, and the total charge or discharge power is larger than the total operating power limit by a second threshold (larger than the first threshold); and stopping, by the first to n-th slave control units, the operation of the battery rack on its own mounted in response to the operation stop message being received.

### Advantageous Effects

According to the present disclosure, when the charge power or discharge power of the power storage source is lower than the unstable power range of the power conversion system, the charge/discharge stop condition is relaxed. Accordingly, it is possible to fully charge and fully discharge the power storage source by preventing the power storage source from stopping operation in the latter stage of charging or discharging. Through this, it is possible to make maximum use of the capacity of the power storage source.

### DESCRIPTION OF DRAWINGS

The accompanying drawings illustrate an exemplary embodiment of the present disclosure, and together with the following detailed description, serve to provide a further understanding of the technical aspects of the present disclosure, and thus the present disclosure should not be construed as being limited to the drawings.
FIG. 1 is a schematic diagram of a power storage source management apparatus according to a first embodiment of the present disclosure.
FIG. 2 is a schematic diagram of a power storage source management apparatus according to a second embodiment of the present disclosure.
FIG. 3 is a flowchart of a method for controlling a power storage source management apparatus according to a first embodiment of the present disclosure.
FIG. 4 is a flowchart of a method for controlling a power storage source management apparatus according to a second embodiment of the present disclosure.

### BEST MODE

Hereinafter, an exemplary embodiment of the present disclosure will be described with reference to the accompanying drawings. Prior to the description, it should be understood that the terms or words used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the embodiments described herein and the illustrations in the drawings are just an exemplary embodiment of the present disclosure and do not fully describe the technical aspect of the present disclosure, so it should be understood that a variety of other equivalents and modifications could have been made thereto at the time of filing the patent application.

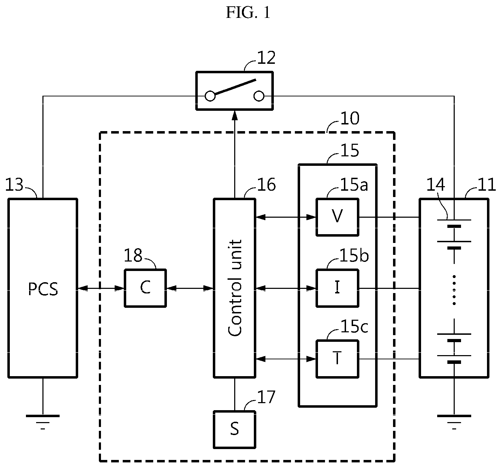

FIG. 1 is a schematic diagram of a power storage source management apparatus 10 according to a first embodiment of the present disclosure.

Referring to FIG. 1, the power storage source management apparatus 10 according to the first embodiment is coupled to a power storage source 11. The power storage source 11 is connected to a Power Conversion System (PCS) 13 through a switch 12. The PCS 13 is included in an Energy Storage System (ESS) and configured to convert the characteristics of the electric current in order to output the power stored in the power storage source 11 to a grid or supply the power of the grid to the power storage source 11, and perform monitor and control, independent operation and grid protection functions.

The power storage source 11 includes a plurality of batteries 14. The plurality of batteries 14 may be connected in series and/or in parallel. In an example, the plurality of batteries may be mounted in a battery rack. The battery rack is widely used in ESSs, and includes a rack structure in which the plurality of batteries 14 can be loaded. Preferably, the battery rack may be the component included in the ESS.

The plurality of batteries 14 may be lithium ion batteries, and the present disclosure is not limited by the type of the battery 14.

The switch 12 is the component used to connect or disconnect the PCS 13 to/from the power storage source 11. The switch 12 may be a relay switch or a power semiconductor switch. However, the present disclosure is not limited by the type of the switch 12.

The power storage source management apparatus 10 includes a sensor unit 15 to measure the operational characteristics of the power storage source 11. Preferably, the sensor unit 15 includes a voltage measurement unit 15a, a current measurement unit 15b and a temperature measurement unit 15c.

The voltage measurement unit 15a measures a voltage of each battery cell at a predetermined time interval during the charging or discharging of the plurality of battery cells 14, and outputs the voltage measurement value to a control unit 16.

The voltage measurement unit 15a may be a voltage measurement circuit known in the corresponding technical field. The voltage measurement circuit is well known, and its detailed description is omitted.

The current measurement unit 15b measures a charge/discharge current flowing through the plurality of battery cells 14 at a predetermined time interval, and outputs the current measurement value to the control unit 16.

The current measurement unit 15b may be a current measurement circuit known in the corresponding technical field. The current measurement unit 15b may be a hall effect sensor or a sense resistor that outputs the voltage value corresponding to the magnitude of the electric current. The voltage value may be converted to the current value according to the Ohm's law.

The temperature measurement unit 15c measures a temperature of each battery cell 14 at a predetermined time interval during charging or discharging of the plurality of battery cells 14 and outputs the temperature measurement value to the control unit 16.

The temperature measurement unit 15c may be a temperature measurement circuit known in the corresponding technical field. The temperature measurement unit 15c may be a thermocouple or a temperature measurement device that outputs the voltage value corresponding to the temperature. The voltage value may be converted to the temperature value using a voltage-temperature conversion lookup table (function).

The power storage source management apparatus 10 includes the control unit 16. The control unit 16 acquires operational characteristics information of the power storage source 11 from the sensor unit 15 and determines an operating power limit of the power storage source 11. The operational characteristics information is associated with the voltage, charge/discharge current and temperature of the plurality of battery cells 14 included in the power storage source 11. Additionally, the operating power limit is the maximum charge power that may be applied to the power storage source 11 or the maximum discharge power that may be outputted from the power storage source 11 to the grid.

The control unit 16 may determine a State Of Charge (SOC) of each battery cell by accumulating the charge/discharge current for each of the plurality of battery cells 14, and determine an SOC of the power storage source 11 by summing the SOCs of the battery cells.

The accumulation of the charge/discharge current is performed using coulomb counting known in the technical field pertaining to the present disclosure. When accumulating the charge/discharge current, the initial value of SOC may be determined using stabilized voltage measured after the plurality of battery cells 14 is kept in no-load condition for a predetermined time. That is, the SOC corresponding to the stabilized voltage may be looked up by referring to lookup information predefining a correlation between stabilized voltage and SOC, and the looked-up SOC may be set as the initial value of SOC.

In another example, the control unit 16 may determine the SOC of each battery cell by inputting the information associated with the voltage, charge/discharge current and temperature of each of the plurality of battery cells 14 to an extended Kalman filter, and determine the SOC of the power storage source 11 by summing the SOCs of the battery cells. The extended Kalman filter used to determine the SOC from the voltage, charge/discharge current and temperature of the battery cell is known in the corresponding technical field.

For the SOC estimation using the extended Kalman filter, for example, reference may be made to Gregory L. Plett's paper "Extended Kalman filtering for battery management systems of LiPB-based HEV battery packs Parts 1, 2 and 3"(Journal of Power Source 134, 2004, 252-261).

Preferably, the control unit 16 may determine the operating power limit corresponding to the current SOC and the current temperature of the power storage source 11 by referring to the lookup information defining a correlation between the SOC and temperature and the operating power limit of the power storage source 11.

The power storage source 11 uniformly maintains the temperature by a Heating, Ventilation, & Air conditioning (HVAC) system. Accordingly, the temperature of the power storage source 11 may be the average temperature of the battery cells. Alternatively, the temperature of the power storage source 11 may be the highest temperature of the battery cells.

In addition to referring to the lookup information, the operating power limit may be determined by any other known method, and the present disclosure is not limited to the particular method for determining the operating power limit.

Additionally, the control unit 16 may determine the charge power supplied from the PCS 13 to the power storage source 11 or the discharge power provided from the power storage source 11 to the PCS 13 during the charging or discharging of the power storage source 11.

To this end, the control unit 16 may determine the charge power or discharge power by multiplication of the total voltage and the charge/discharge current of the plurality of battery cells 14. The total voltage may be determined by summing the voltage of each battery cell. The voltage and the charge/discharge current of each battery cell may be obtained by referring to the operational characteristics information obtained through the sensor unit 15.

The control unit 16 may determine the charge power supplied from the PCS 13 to the power storage source 11 or the discharge power provided from the power storage source 11 to the PCS 13 by directly measuring the current and voltage of the power line to which the PCS 13 and the power storage source 11 are connected. In this case, the power storage source management apparatus 10 may include a current measurement unit (not shown) and a voltage measurement unit (not shown) to monitor the current and voltage of the power line, respectively.

The control unit 16 may maintain or stop the operation of the power storage source 11 by determining whether or not the charge power or discharge power of the power storage source 11 belongs to the preset unstable power range of the PCS 13, and whether or not the charge power or discharge power is larger than the operating power limit by the threshold.

According to an aspect, the control unit 16 may determine if a condition (a first operation stop condition) is met in which the charge power or discharge power of the power storage source 11 is larger than the preset unstable power range of the PCS 13, and the charge power or discharge power is larger than the operating power limit of the power storage source 11 by a first threshold. When the first operation stop condition is met, the control unit 16 may turn off the switch 12 to stop charging or discharging the power storage source 11. On the contrary, when the first operation stop condition is not met, the control unit 16 may keep the switch 12 in the turn-on state to keep charging or discharging the power storage source 11.

According to another aspect, the control unit 16 may determine if a condition (a second operation stop condition) is met in which the charge power or discharge power of the power storage source 11 is within the preset unstable power range of the PCS 13, and the charge power or discharge power is larger than the operating power limit of the power storage source 11 by a second threshold (larger than the first threshold). When the second operation stop condition is met, the control unit 16 may turn off the switch 12 to stop charging or discharging the power storage source 11. On the contrary, when the second operation stop condition is not met, the control unit 16 may keep the switch 12 in the turn-on state to keep charging or discharging the power storage source 11.

The first threshold may be set to 10% to 30% of the operating power limit. In this case, the control unit 16 may stop the operation of the power storage source 11 when the condition is met in which the charge power or discharge power of the power storage source 11 is larger than the preset unstable power range of the PCS 13, and the charge power or discharge power is 10% to 30% larger than the operating power limit.

The second threshold may be set to 30% to 60% of the operating power limit. In this case, the control unit 16 may stop the operation of the power storage source 11 when the condition is met in which the charge power or discharge power of the power storage source 11 is within the preset unstable power range of the PCS 13, and the charge power or discharge power is 30% to 60% larger than the operating power limit of the power storage source 11.

According to the present disclosure, the second operation stop condition is applied when the charge power or discharge power of the power storage source 11 is within the preset unstable power range of the PCS 13. The unstable power range results from voltage and current measurement errors of the PCS. In an example, when the voltage and current measurement error is 1%, the unstable power range is a power range corresponding to the "power specification of the PCS*the measurement error". When the power specification of the PCS is 5000 kW, the unstable power range is between 0 and 50 kW.

The time when the charge power or discharge power of the power storage source 11 goes into the unstable power range is the time when the power storage source 11 is close to full charge state or full discharge state. In this time, since the charge power or discharge power is very low, even though the second threshold is larger than the first threshold, the safety issue does not arise. Since the power storage source 11 includes the plurality of battery cells 14, even though the second threshold is larger than the first threshold, the extent of exceeding the operating power limit is not such a level to worry about in the view of each battery cell.

As described above, when the charge power or discharge power of the PCS 13 goes into the unstable power range, the increase of the charge/discharge stop condition of the power storage source 11 from the first threshold to the second threshold makes it possible to prevent the power storage source 11 from suddenly stopping in the latter stage of charging or discharging without causing the safety issue of the battery cell, and make use of the power storage source 11 from full charge to full discharge state. Through this, it is possible to improve the energy usage efficiency.

Meanwhile, the second threshold may adaptively change depending on the level of the charge power or discharge power of the power storage source 11. In an example, when the charge power or discharge power of the power storage source 11 belongs to the preset unstable power range of the PCS 13, as the charge or discharge power is smaller, the second threshold may gradually increase. It is because as the charge power or discharge power is lowered, there is a lower likelihood that the safety issue of the battery cell occurs.

The power storage source management apparatus 10 may further include a storage medium 17 and a communication interface 18.

The storage medium 17 is not limited to a particular type and includes any type of storage medium that can record and erase data and/or information. For example, the storage medium 17 may be RAM, ROM, register, flash memory, hard disk or magnetic recording medium.

The storage medium 17 may be electrically connected to the control unit 16, for example, through a data bus to allow the control unit 16 to access.

The storage medium 17 stores and/or updates and/or erases and/or transmits programs including the control logics executed by the control unit 16 and/or data generated when the control logics are executed and/or preset data or lookup information/tables.

The control unit 16 transmits and receives information and/or data to/from the PCS 13 through the communication interface 18. Preferably, the control unit 16 may receive information associated with the unstable power range of the PCS 13 through the communication interface 18 and record it in the storage medium 17. The information associated with the unstable power range stored in the storage medium 17 may be referenced when determining if the first operation stop condition and the second operation stop condition are met.

Additionally, the control unit 16 may transmit the operating power limit to the PCS 13 through the communication interface 18. Then, the PCS 13 supplies the charge power to the power storage source 11 not to exceed the operating power limit. In this instance, the PCS 13 converts AC power of the power grid to DC power corresponding to the charge power and provides it to the power storage source 11. Additionally, the PCS 13 is supplied with the DC discharge power from the power storage source 11 within the range that does not exceed the operating power limit and supply it to the power grid after converting DC power to AC power.

The communication interface 18 may be a known wired or wireless communication interface that supports near-field communication or long distance communication. For example, the communication interface 18 may be a near-field wireless communication interface such as a CAN communication interface, a daisy-chain interface, an Ethernet communication interface, WI-FI; Bluetooth; or Zigbee, but the present disclosure is not limited thereto.

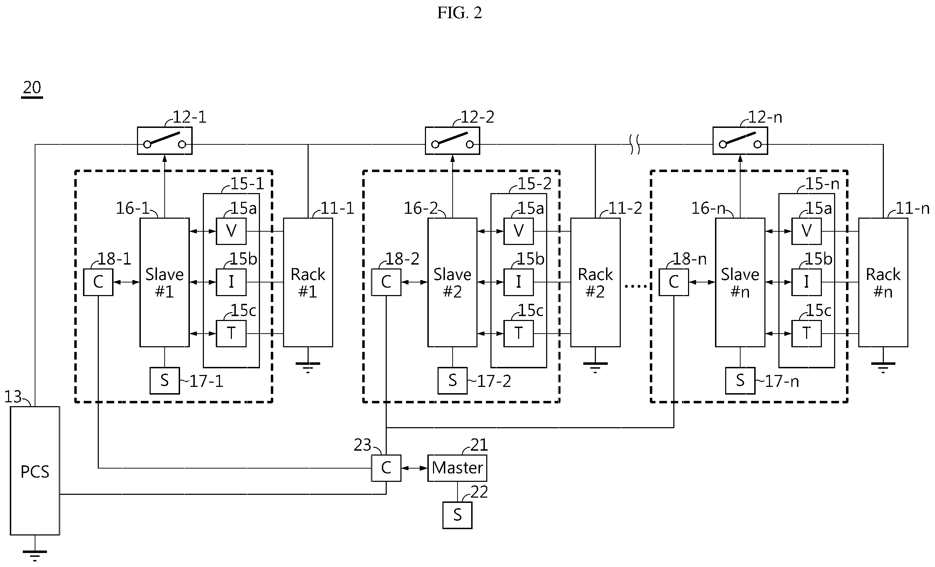

FIG. 2 is a schematic diagram of a power storage source management apparatus 20 according to a second embodiment of the present disclosure.

Referring to FIG. 2, in the second embodiment, the power storage source 11 includes first to n-th battery racks 11-1~11-n. In the same way as the power storage source 11 of the first embodiment, each battery rack includes a plurality of battery cells connected in series and/or in parallel.

The power storage source management apparatus 20 includes first to n-th slave control units 16-1~16-n respectively coupled to the first to n-th battery racks 11-1~11-n. The first to n-th slave control units 16-1~16-n include first to n-th sensor units 15-1~15-n respectively coupled to the first to n-th battery racks 11-1~11-n. In the same way as the first embodiment, the first to n-th sensor units 15-1~15-n include a voltage measurement unit 15a, a current measurement unit 15b and a temperature measurement unit 15c.

Additionally, the power storage source management apparatus 20 includes first to n-th storage medium 17-1~17-n respectively coupled to the first to n-th slave control units 16-1~16-n. Additionally, the power storage source management apparatus 20 includes first to n-th communication interfaces 18-1-18-n respectively coupled to the first to n-th slave control units 16-1~16-n. The first to n-th storage medium 17-1~17-n and the first to n-th communication interfaces 18-1-18-n are substantially the same as those of the first embodiment.

Additionally, the power storage source management apparatus 20 includes a master control unit 21. The master control unit 21 may be operably coupled to a storage medium 22 and a communication interface 23. The storage medium 22 and the communication interface 23 are substantially the same as the storage medium 17 and the communication interface 18 of the first embodiment.

The master control unit 21 may transmit and receive data and/or information to/from the first to n-th slave control units 16-1~16-n through the communication interface 23.

In the following description, when the master control unit 21 and the first to n-th slave control units 16-1~16-n transmit and receive data and/or information, obviously, the communication interfaces 16-1~16-n, 23 will be used. Accordingly, the mention of the communication interfaces is omitted when describing the transmission/reception of data and/or information between the control units.

Preferably, the first to n-th slave control units 16-1 ~ 16-n perform substantially the same operation.

Specifically, the first slave control unit 16-1 acquires operational characteristics information from the sensor unit 15-1 which measures the operational characteristics of the first battery rack 11-1 in which the first slave control unit 16-1 is mounted, determines an operating power limit of the first battery rack 11-1 and transmits it to the master control unit 21 via communication. The second slave control unit 16-2 to the n-th slave control unit 16-n also determine the operating power limit of the second to n-th battery racks 11-2~11-n in which the second slave control unit 16-2 to the n-th slave control unit 16-n are respectively mounted, and transmits it to the master control unit 21 via communication. The method for determining the operating power limit is substantially the same as that of the first embodiment.

Additionally, the first slave control unit 16-1 determines the charge power or discharge power during the charging or discharging of the first battery rack 11-1 and provides the charge power or discharge power to the master control unit 21 via communication. The second slave control unit 16-2 to the n-th slave control unit 16-n also determine the charge power or discharge power of the second to n-th battery racks 11-2~11-n in which the second slave control unit 16-2 to the n-th slave control unit 16-n are respectively mounted and transmit it to the master control unit 21 via communication. The method for determining the charge power or discharge power is substantially the same as that of the first embodiment.

When the operating power limit is transmitted from the first to n-th slave control units 16-1~16-n, the master control unit 21 may determine the total operating power limit of the first to n-th battery racks 11-1~11-n by summing each value.

Additionally, when the charge power or discharge power is transmitted from the first to n-th slave control units 16-1~16-n, the master control unit 21 may determine the total charge or discharge power of the first to n-th battery racks 11-1~11-n by summing each value.

According to an aspect, additionally, the master control unit 21 determines if a condition (a first operation stop condition) is met in which the total charge or discharge power is larger than the preset unstable power range of the PCS 13 and the total charge or discharge power is larger than the total operating power limit by a first threshold. Preferably, in the same way as the first embodiment, the first threshold may be set to 10% to 30% of the total operating power limit, but the present disclosure is not limited thereto.

When the first operation stop condition is met, the master control unit 21 transmits an operation stop message to the first to n-th slave control units 16-1~16-n via communication. In contrast, when the first operation stop condition is not met, the master control unit 21 transmits an operation maintenance message to the first to n-th slave control units 16-1~16-n via communication.

According to another aspect, the master control unit 21 determines if a condition (a second operation stop condition) is met in which the total charge or discharge power is within the preset unstable power range of the PCS 13, and the total charge or discharge power is larger than the total operating power limit by a second threshold (larger than the first threshold). Preferably, in the same way as the first embodiment, the second threshold may be set to 30% to 60% of the total operating power limit, but the present disclosure is not limited thereto.

When the second operation stop condition is met, the master control unit 21 transmits the operation stop message to the first to n-th slave control units 16-1~16-n via communication. In contrast, when the second operation stop condition is not met, the master control unit 21 transmits the operation maintenance message to the first to n-th slave control units 16-1~16-n via communication.

When the first slave control unit 16-1 receives the operation stop message from the master control unit 21 via communication, the first slave control unit 16-1 turns off the switch 12-1 installed in the first battery rack 11-1 in which the first slave control unit 16-1 is mounted, to stop charging or discharging the first battery rack 11-1. In contrast, when the first slave control unit 16-1 receives the operation maintenance message from the master control unit 21 via communication, the first slave control unit 16-1 maintains the turn-on state of the switch 12-1 installed in the first battery rack 11-1 in which the first slave control unit 16-1 is mounted, to keep charging or discharging the first battery rack 11-1.

In the same way as the first slave control unit 16-1, when the second to n-th slave control units 16-2~16-n receive the operation stop message via communication, the second to n-th slave control units 16-2~16-n stop the operation of the battery rack in which the second to n-th slave control units 16-2~16-n are respectively mounted, and on the contrary, when the second to n-th slave control units 16-2~16-n receive the operation maintenance message via communication, the second to n-th slave control units 16-2~16-n maintain the operation of the battery rack in which the second to n-th slave control units 16-2~16-n are respectively mounted.

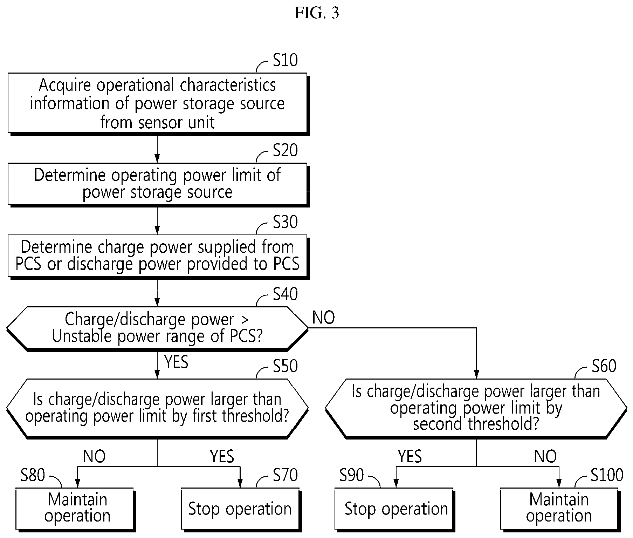

FIG. 3 is a flowchart of a method for controlling the power storage source management apparatus according to the first embodiment of the present disclosure.

The method shown in FIG. 3 is a method for controlling the power storage source management apparatus 10 according to the first embodiment, and unless otherwise stated, the steps of FIG. 3 are performed by the control unit 16 of the first embodiment. Additionally, the steps of FIG. 3 may be periodically repeated at a predetermined time interval.

Referring to FIGS. 1 and 3, in step S10, the control unit 16 acquires the operational characteristics information of the power storage source 11 from the sensor unit 15.

Subsequently, in step S20, the control unit 16 determines the operating power limit of the power storage source 11 using the operational characteristics information.

Subsequently, in step S30, the control unit 16 determines the charge power supplied from the PCS 13 to the power storage source 11 or the discharge power supplied from the power storage source 11 to the PCS 13.

Subsequently, in step S40, the control unit 16 determines if the charge power or discharge power of the power storage source 11 is larger than the preset unstable power range of the PCS 13.

When the determination of the step S40 is YES, in step S50, the control unit 16 determines if the charge power or discharge power of the power storage source 11 is larger than the operating power limit corresponding to the SOC and temperature of the power storage source 11 by the first threshold.

When the determination of the step S50 is YES, in step S70, the control unit 16 turns off the switch 12 installed in the power line to stop the operation of the power storage source 11. In contrast, when the determination of the step S50 is NO, in step S80, the control unit 16 maintains the turn-on state of the switch 12 installed in the power line to maintain the operation of the power storage source 11.

On the other hand, when the determination of the step S40 is NO, in step S60, the control unit 16 determines if the charge power or discharge power of the power storage source 11 is larger than the operating power limit corresponding to the SOC and temperature of the power storage source 11 by the second threshold (larger than the first threshold).

When the determination of the step S60 is YES, in step S90, the control unit 16 turns off the switch 12 installed in the power line to stop the operation of the power storage source 11. In contrast, when the determination of the step S60 is NO, in step S100, the control unit 16 maintains the turn-on state of the switch 12 installed in the power line to maintain the operation of the power storage source 11.

According to the present disclosure, it is possible to prevent the power storage source 11 from stopping operation in the latter stage of charging or discharging by increasing the charge/discharge stop condition of the power storage source 11 when the charge power or discharge power of the power storage source 11 belongs to the preset unstable power range of the PCS 13. Accordingly, it is possible to fully charge and fully discharge the power storage source 11, thereby making maximum use of the capacity of the power storage source 11.

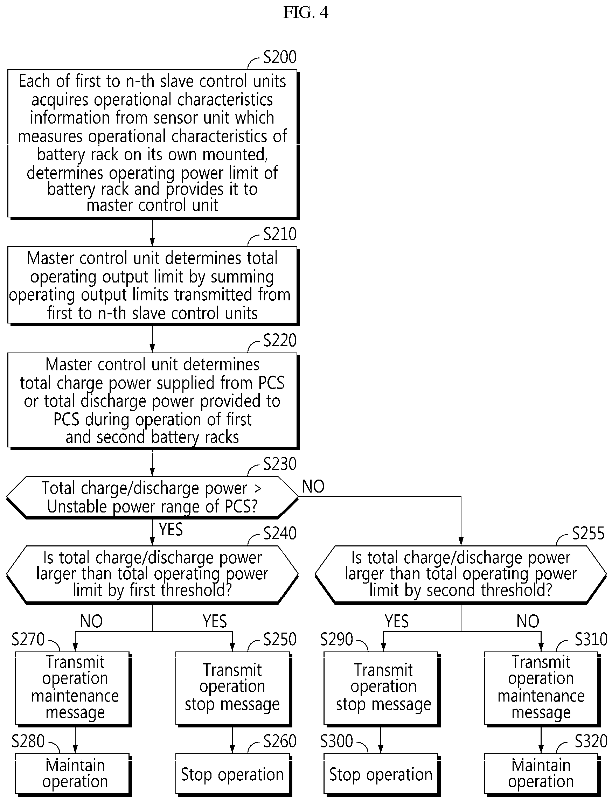

FIG. 4 is a flowchart of a method for controlling the power storage source management apparatus 20 according to the second embodiment of the present disclosure.

The method shown in FIG. 4 is a method for controlling the power storage source management apparatus 20 according to the second embodiment, and the steps of FIG. 4 are performed by the first to n-th slave control units 16-1~16-n or the master control unit 21 of the second embodiment. Additionally, the steps of FIG. 4 may be periodically repeated at a predetermined time interval.

Referring to FIGS. 2 and 4, in step S200, the first slave control unit 16-1 acquires the operational characteristics information from the sensor unit 15-1 which measures the operational characteristics of the first battery rack 11-1 in which the first slave control unit 16-1 is mounted, determines the operating power limit of the first battery rack 11-1 and provides it to the master control unit 21. In the same way as the first slave control unit 16-1, the second to n-th slave control units 16-2~16-n determine the operating power limit of the second to n-th battery racks 11-2~11-n and provide it to the master control unit 21.

Subsequently, in step S210, the master control unit 21 determines the total operating power limit by summing the operating power limits transmitted from the first to n-th slave control units 16-1~16-n.

Subsequently, in step S220, the master control unit 21 determines the total charge power supplied from the PCS 13 or the total discharge power supplied to the PCS 13 during the operation of the first and n-th battery racks 11-1~11-n.

To determine the total charge or discharge power, the first to n-th slave control units 16-1~16-n may determine the charge power or discharge power of the battery rack in which the first to n-th slave control units 16-1~16-n are respectively mounted, and transmit it to the master control unit 21 via communication. Then, the master control unit 21 may determine the total charge or discharge power by summing the charge power or discharge power of each battery rack. Alternatively, the master control unit 21 may measure the voltage and current of the power line using the voltage measurement unit (not shown) and the current measurement unit (not shown) installed in the power line, respectively, and determine the total charge or discharge power through multiplication of the voltage and current. The method for determining the charge or discharge power of each battery rack is the same as described above.

The step S220 is followed by step S230.

In the step S230, the master control unit 21 determines if the total charge or discharge power is larger than the preset unstable power range of the PCS 13.

When the determination of the step S230 is YES, in S240, the master control unit 21 determines if the total charge or discharge power is larger than the total operating power limit by the first threshold.

When the determination of the step S240 is YES, in step S250, the master control unit 21 transmits the operation stop message to the first to n-th slave control units 16-1-16-n via communication. Then, in step S260, the first to n-th slave control units 16-1~16-n turn off the switch of the battery rack in which the first to n-th slave control units 16-1-16-n are respectively mounted, to stop the operation of the battery rack.

When the determination of the step S240 is NO, in step S270, the master control unit 21 transmits the operation maintenance message to the first to n-th slave control units 16-1~16-n via communication. Then, in step S280, the first to n-th slave control units 16-1~16-n maintain the turn-on state of the switch of the battery rack in which the first to n-th slave control units 16-1~16-n are respectively mounted, to maintain the operation of the battery rack.

On the other hand, when the determination of the step S230 is NO, in step S255, the master control unit 21 determines if the total charge or discharge power is larger than the total operating power limit by the second threshold (larger than the first threshold).

When the determination of the step S255 is YES, in step S290, the master control unit 21 transmits the operation stop message to the first to n-th slave control units 16-1-16-n via communication. Then, in step S300, the first to n-th slave control units 16-1~16-n turn off the switch of the battery rack in which the first to n-th slave control units 16-1-16-n are respectively mounted, to stop the operation of the battery rack.

When the determination of the step S255 is NO, in step S310, the master control unit 21 transmits the operation maintenance message to the first to n-th slave control units 16-1~16-n via communication. Then, in step S320, the first to n-th slave control units 16-1~16-n maintain the turn-on state of the switch of the battery rack in which the first to n-th slave control units 16-1~16-n are respectively mounted, to maintain the operation of the battery rack.

According to the present disclosure, it is possible to prevent the first to n-th battery racks 11-1-11-n from stopping operation in the latter stage of charging or discharging by increasing the charge/discharge stop condition of the first to n-th battery racks 11-1~11-n when the total charge or discharge power of the first to n-th battery racks 11-1~11-n belongs to the preset unstable power range of the PCS 13. Accordingly, it is possible to fully charge and fully discharge the first to n-th battery racks 11-1~11-n, thereby making maximum use of the capacity of the first to n-th battery racks 11-1~11-n.

In the present disclosure, the control units 16, 16-1-16-n, 21 may be control circuits. The control units 16, 16-1~16-n, 21 may selectively include a processor, an application-specific integrated circuit (ASIC), a chipset, a logic circuit, register, a communication modem, a data processing device or the like, known in the corresponding technical field to execute the above-described control logics. Additionally, when the control logics are implemented in software, the control units 16, 16-1~16-n, 21 may be designed as a collection of program modules. In this instance, the program modules may be stored in memory and executed by the processor. The memory may be inside or outside of the processor, and may be connected to the processor with a variety of known computer components. Additionally, the memory may be included in the storage medium 17, 17-1~17-n, 22 of the present disclosure. Additionally, the memory refers collectively to devices that store information irrespective of device type and does not refer to a particular memory device.

At least one of the control logics of the control units 16, 16-1~16-n, 21 may be combined together, and the combined control logics may be written in computer-readable code and recorded in a computer-readable recording medium. The recording medium is not limited to a particular type and includes any type of recording medium that can be accessed by the processor included in the computer. For example, the recording medium includes at least one selected from the group consisting of ROM, RAM, register, CD-ROM, magnetic tape, hard disk, floppy disk and an optical data recording device. Additionally, the code may be stored and executed in distributed computers connected via a network. Additionally, the functional programs, code and code segments for implementing the combined control logics can be easily inferred by programmers in the technical field pertaining to the present disclosure

In describing the various embodiments of the present disclosure, the components called '~ unit' should be understood as components that are functionally divided rather than physically. Accordingly, each component may be selectively combined with other component or split into subcomponents for the efficient execution of the control logic(s). However, it is obvious to those skilled in the art that even though the components are combined or split, the combined or split components should be interpreted as falling within the scope of the present disclosure in case that the identity of function is acknowledged.

## Claims

1. A power storage source management apparatus (10), comprising:
a sensor unit (15) configured to measure operational characteristics of a power storage source (11); and
a control unit (16) operably coupled to the sensor unit,
wherein the control unit is configured to:
(i) acquire operational characteristics information of the power storage source from the sensor unit and determine an operating power limit of the power storage source,
(ii) determine a charge power supplied from a Power Conversion System (13), PCS, or a discharge power provided to the PCS using the operational characteristics information during operation of the power storage source,
(iii) stop the operation of the power storage source in response to a first operation stop condition being met in which the charge power or discharge power is larger than a preset unstable power range of the PCS, and the charge power or discharge power is larger than the operating power limit by a first threshold, and
(iv) stop the operation of the power storage source in response to a second operation stop condition being met in which the charge power or discharge power is within the preset unstable power range of the PCS, and the charge power or discharge power is larger than the operating power limit by a second threshold larger than the first threshold.

2. The power storage source management apparatus according to claim 1, wherein the control unit is configured to receive the operational characteristics information including a charge/discharge current, voltage and temperature of the power storage source from the sensor unit, determine a state of charge, SOC, of the power storage source (11) by accumulating the charge/discharge current, and determine the operating power limit of the power storage source corresponding to the determined SOC and the received temperature by referring to lookup information defining a correlation between the SOC and temperature and the operating power limit.

3. The power storage source management apparatus according to claim 1, wherein the control unit (16)
receives information associated with the preset unstable power range of the PCS from the PCS.

4. The power storage source management apparatus according to claim 1, wherein the first threshold is 10% to 30% of the operating power limit.

5. The power storage source management apparatus according to claim 1, wherein the second threshold is 30% to 60% of the operating power limit.

6. The power storage source management apparatus according to claim 5, wherein the second threshold increases as the charge power or discharge power of the power storage source decreases.

7. The power storage source management apparatus according to claim 1, wherein the power storage source includes first to n-th battery racks.

8. A power storage source management apparatus (10), comprising:
first to n-th slave control units (16-1 - 16-n) respectively mounted in first to n-th battery racks (11-1 - 11-n); and
a master control unit (21) coupled to the first to n-th slave control units to enable communication therebetween,
wherein each of the first to n-th slave control units is configured to acquire operational characteristics information of the battery rack on its own mounted from a sensor unit (15-1 - 15-n), determine an operating power limit and a charge or discharge power of the battery rack using the operational characteristics information and provide the same to the master control unit, and
wherein the master control unit is configured to:
determine a total operating power limit and a total charge or discharge power by summing the operating power limits and the charge or discharge power transmitted from the first to n-th slave control units,
provide an operation stop message to the first to n-th slave control units in response to a first operation stop condition being met in which the total charge or discharge power is larger than a preset unstable power range of a Power Conversion System, PCS, and the total charge or discharge power is larger than the total operating power limit by a first threshold, and
provide the operation stop message to the first to n-th slave control units in response to a second operation stop condition being met in which the total charge or discharge power is within the preset unstable power range of the PCS and the total charge or discharge power is larger than the total operating power limit by a second threshold larger than the first threshold.

9. A method for controlling a power storage source management apparatus (10), comprising:
acquiring operational characteristics information of a power storage source (11) from a sensor unit (15) which measures operational characteristics of the power storage source:
determining an operating power limit of the power storage source using the operational characteristics information;
determining a charge power supplied from a Power Conversion System, PCS, or a discharge power provided to the PCS using the operational characteristics information during operation of the power storage source;
stopping the operation of the power storage source in response to a first operation stop condition being met in which the charge or discharge power is larger than a preset unstable power range of the PCS, and the charge or discharge power is larger than the operating power limit by a first threshold; and
stopping the operation of the power storage source in response to a second operation stop condition being met in which the charge power or discharge power is within the preset unstable power range of the PCS, and the charge power or discharge power is larger than the operating power limit by a second threshold larger than the first threshold.

10. The method for controlling a power storage source management apparatus according to claim 9, wherein the method comprises:
receiving the operational characteristics information including a charge/discharge current, voltage and temperature of the power storage source from the sensor unit;
determining a state of charge, SOC, of the power storage source by accumulating the charge/discharge current; and
determining the operating power limit of the power storage source corresponding to the determined SOC and the received temperature by referring to lookup information defining a correlation between the SOC and temperature and the operating power limit.

11. The method for controlling a power storage source management apparatus according to claim 9, further comprising:
receiving information associated with the preset unstable power range of the PCS from the PCS.

12. The method for controlling a power storage source management apparatus according to claim 9, wherein the first threshold is 10% to 30% of the operating power limit.

13. The method for controlling a power storage source management apparatus according to claim 9, wherein the second threshold is 30% to 60% of the operating power limit.

14. The method for controlling a power storage source management apparatus according to claim 13, wherein the second threshold increases as the charge or discharge power of the power storage source decreases.

15. A method for controlling a power storage energy management apparatus (10), the power storage source management apparatus including first to n-th slave control units (16-1 - 16-n) respectively mounted in first to n-th battery racks (11-1 - 11-n) and a master control unit (21) coupled to the first to n-th slave control units to enable communication therebetween, the method comprising:
acquiring, by each of the first to n-th slave control units, operational characteristics information from a sensor unit (15-1 - 15-n) which measures operational characteristics of the battery rack on its own mounted, determining an operating power limit and a charge or discharge power of the battery rack and providing the same to the master control unit;
determining, by the master control unit, a total operating power limit and a total charge or discharge power by summing the operating power limits and the charge or discharge power transmitted from the first to n-th slave control units;
providing, by the master control unit, an operation stop message to the first to n-th slave control units in response to a first operation stop condition being met in which the total charge or discharge power is larger than a preset unstable power range of the PCS, and the total charge or discharge power is larger than the total operating power limit by a first threshold;
providing, by the master control unit, the operation stop message to the first to n-th slave control units in response to a second operation stop condition being met in which the total charge or discharge power is within the preset unstable power range of the PCS, and the total charge or discharge power is larger than the total operating power limit by a second threshold larger than the first threshold; and
stopping, by the first to n-th slave control units, the operation of the battery rack on its own mounted in response to the operation stop message being received.

## Patentansprüche

1. Vorrichtung (10) zur Verwaltung einer Energiespeicherquelle, umfassend:
eine Sensoreinheit (15), welche dazu eingerichtet ist, Betriebseigenschaften einer Energiespeicherquelle (11) zu messen; und
eine Steuereinheit (16), welche betriebsmäßig mit der Sensoreinheit gekoppelt ist,
wobei die Steuereinheit dazu eingerichtet ist:
(i) Betriebseigenschaften-Informationen der Energiespeicherquelle von der Sensoreinheit zu akquirieren und eine Betriebsleistungsgrenze der Energiespeicherquelle zu bestimmen,
(ii) eine Ladeleistung, welche von einem Power Conversion System (13), PCS, geliefert wird, oder eine Entladeleistung zu bestimmen, welche an das PCS bereitgestellt wird, unter Verwendung der Betriebseigenschaften-Informationen während eines Betriebs der Energiespeicherquelle,
(iii) den Betrieb der Energiespeicherquelle in Reaktion darauf zu stoppen, dass eine erste Betriebsstopp-Bedingung erfüllt ist, in welcher die Ladeleistung oder Entladeleistung größer als ein vorfestgelegter instabiler Leistungsbereich des PCS ist, und die Ladeleistung oder Entladeleistung um einen ersten Schwellenwert größer als die Betriebsleistungsgrenze ist, und
(iv) den Betrieb der Energiespeicherquelle in Reaktion darauf zu stoppen, dass eine zweite Betriebsstopp-Bedingung erfüllt ist, in welcher die Ladeleistung oder Entladeleistung innerhalb des vorfestgelegten instabilen Leistungsbereichs des PCS ist, und die Ladeleistung oder Entladeleistung um einen zweiten Schwellenwert, welcher größer als der erste Schwellenwert ist, größer als die Betriebsleistungsgrenze ist.

2. Vorrichtung zur Verwaltung einer Energiespeicherquelle nach Anspruch 1, wobei die Steuereinheit dazu eingerichtet ist, die Betriebseigenschaften-Informationen, welche einen Lade-/ Entladestrom, Spannung und Temperatur der Energiespeicherquelle umfassen, von der Sensoreinheit zu empfangen, einen Ladezustand, SOC, der Energiespeicherquelle (11) durch Akkumulieren des Lade-/ Entladestroms zu bestimmen und die Betriebsleistungsgrenze der Energiespeicherquelle entsprechend dem bestimmten SOC und der empfangenen Temperatur durch ein Bezugnehmen auf Nachschlageinformationen, welche eine Korrelation zwischen dem SOC und der Temperatur und der Betriebsleistungsgrenze definieren.

3. Vorrichtung zur Verwaltung einer Energiespeicherquelle nach Anspruch 1, wobei die Steuereinheit (16) Informationen, welche mit dem vorfestgelegten instabilen Leistungsbereich des PCS verbunden sind, von dem PCS empfängt.

4. Vorrichtung zur Verwaltung einer Energiespeicherquelle nach Anspruch 1, wobei der erste Schwellenwert 10 % bis 30 % der Betriebsleistungsgrenze ist.

5. Vorrichtung zur Verwaltung einer Energiespeicherquelle nach Anspruch 1, wobei der zweite Schwellenwert 30 % bis 60 % der Betriebsleistungsgrenze ist.

6. Vorrichtung zur Verwaltung einer Energiespeicherquelle nach Anspruch 5, wobei der zweite Schwellenwert steigt, wenn die Ladeleistung oder die Entladeleistung der Energiespeicherquelle sinkt.

7. Vorrichtung zur Verwaltung einer Energiespeicherquelle nach Anspruch 1, wobei die Energiespeicherquelle erste bis n-te Batteriegestelle umfasst.

8. Vorrichtung (10) zur Verwaltung einer Energiespeicherquelle, umfassend:
erste bis n-te Slave-Steuereinheiten (16-1 - 16-n), welche jeweils in erste bis n-te Batteriegestelle (11-1 - 11-n) angebracht sind, und
eine Master-Steuereinheit (21), welche mit den ersten bis n-ten Slave-Steuereinheiten gekoppelt ist, um eine Kommunikation zwischen diesen zu ermöglichen,
wobei jede aus den ersten bis n-ten Slave-Steuereinheiten dazu eingerichtet ist, Betriebseigenschaften-Informationen des Batteriegestells, welches alleine angebracht ist, von einer Sensoreinheit (15-1 - 15-n) zu akquirieren, eine Betriebsleistungsgrenze und eine Lade- oder Entladeleistung des Batteriegestells unter Verwendung der Betriebseigenschaften-Informationen zu bestimmen und die gleichen an die Master-Steuereinheit bereitzustellen, und
wobei die Master-Steuereinheit dazu eingerichtet ist:
eine gesamte Betriebsleistungsgrenze und eine gesamte Lade- oder Entladeleistung durch Summieren der Betriebsleistungsgrenzen und der Lade- oder Entladeleistung zu bestimmen, welche von den ersten bis n-ten Slave-Steuereinheiten übertragen werden,
eine Betriebsstopp-Nachricht an die ersten bis n-ten Slave-Steuereinheiten in Reaktion darauf bereitzustellen, dass eine erste Betriebsstopp-Bedingung erfüllt ist, in welcher die gesamte Lade- oder Entladeleistung größer als ein vorfestgelegter instabiler Leistungsbereich eines Power Conversion Systems, PCS, ist, und die gesamte Lade- oder Entladeleistung um einen ersten Schwellenwert größer als die gesamte Betriebsleistungsgrenze ist,
die Betriebsstopp-Nachricht an die ersten bis n-ten Slave-Steuereinheiten in Reaktion darauf bereitzustellen, dass eine zweite Betriebsstopp-Bedingung erfüllt ist, in welcher die gesamte Lade- oder Entladeleistung innerhalb des vorfestgelegten instabilen Leistungsbereichs des PCS ist und die gesamte Ladeleistung oder Entladeleistung um einen zweiten Schwellenwert, welcher größer als der erste Schwellenwert ist, größer als die gesamte Betriebsleistungsgrenze ist.

9. Verfahren zum Steuern einer Vorrichtung (10) zur Verwaltung einer Energiespeicherquelle, umfassend:
Akquirieren von Betriebseigenschaften-Informationen einer Energiespeicherquelle (11) von einer Sensoreinheit (15), welche Betriebseigenschaften der Energiespeicherquelle misst;
Bestimmen einer Betriebsleistungsgrenze der Energiespeicherquelle unter Verwendung der Betriebseigenschaften-Informationen;
Bestimmen einer Ladeleistung, welche von einem Power Conversion System, PCS, geliefert wird, oder einer Entladeleistung, welche an das PCS bereitgestellt wird, unter Verwendung der Betriebseigenschaften-Informationen während eines Betriebs der Energiespeicherquelle;
Stoppen des Betriebs der Energiespeicherquelle in Reaktion darauf, dass eine erste Betriebsstopp-Bedingung erfüllt ist, in welcher die Ladeleistung oder Entladeleistung größer als ein vorfestgelegter instabiler Leistungsbereich des PCS ist, und die Ladeleistung oder Entladeleistung um einen ersten Schwellenwert größer als die Betriebsleistungsgrenze ist; und
Stoppen des Betriebs der Energiespeicherquelle in Reaktion darauf, dass eine zweite Betriebsstopp-Bedingung erfüllt ist, in welcher die Ladeleistung oder Entladeleistung innerhalb des vorfestgelegten instabilen Leistungsbereichs des PCS ist, und die Ladeleistung oder Entladeleistung um einen zweiten Schwellenwert, welcher größer als der erste Schwellenwert ist, größer als die Betriebsleistungsgrenze ist.

10. Verfahren zum Steuern einer Vorrichtung zur Verwaltung einer Energiespeicherquelle nach Anspruch 9, wobei das Verfahren umfasst:
Empfangen der Betriebseigenschaften-Informationen, welche einen Lade-/ Entladestrom, Spannung und Temperatur der Energiespeicherquelle umfassen, von der Sensoreinheit,
Bestimmen eines Ladezustands, SOC, der Energiespeicherquelle durch Akkumulieren des Lade-/ Entladestroms; und
Bestimmen der Betriebsleistungsgrenze der Energiespeicherquelle entsprechend dem bestimmten SOC und der empfangenen Temperatur durch ein Bezugnehmen auf Nachschlageinformationen, welche eine Korrelation zwischen dem SOC und der Temperatur und der Betriebsleistungsgrenze definieren.

11. Verfahren zum Steuern einer Vorrichtung zur Verwaltung einer Energiespeicherquelle nach Anspruch 9, ferner umfassend:
Empfangen von Informationen von dem PCS, welche mit dem vorfestgelegten instabilen Leistungsbereich des PCS verbunden sind.

12. Verfahren zum Steuern einer Vorrichtung zur Verwaltung einer Energiespeicherquelle nach Anspruch 9, wobei der erste Schwellenwert 10 % bis 30 % der Betriebsleistungsgrenze ist.

13. Verfahren zum Steuern einer Vorrichtung zur Verwaltung einer Energiespeicherquelle nach Anspruch 9, wobei der zweite Schwellenwert 30 % bis 60 % der Betriebsleistungsgrenze ist.

14. Verfahren zum Steuern einer Vorrichtung zur Verwaltung einer Energiespeicherquelle nach Anspruch 13, wobei der zweite Schwellenwert steigt, wenn die Ladeleistung oder die Entladeleistung der Energiespeicherquelle sinkt.

15. Verfahren zum Steuern einer Vorrichtung (10) zur Verwaltung einer Energiespeicherquelle, wobei die Vorrichtung zur Verwaltung einer Energiespeicherquelle erste bis n-te Slave-Steuereinheiten (16-1 - 16-n), welche jeweils in erste bis n-te Batteriegestelle (11-1 - 11-n) angebracht sind, und eine Master-Steuereinheit (21) umfasst, welche mit den ersten bis n-ten Slave-Steuereinheiten gekoppelt ist, um eine Kommunikation zwischen diesen zu ermöglichen, wobei das Verfahren umfasst:
Akquirieren, durch jede aus den ersten bis n-ten Slave-Steuereinheiten, von Betriebseigenschaften-Informationen von einer Sensoreinheit (15-1 - 15-n), welche Betriebseigenschaften des Batteriegestells misst, welches allein angebracht ist, Bestimmen einer Betriebsleistungsgrenze und einer Lade- oder Entladeleistung des Batteriegestells und Bereitstellen der gleichen an die Master-Steuereinheit;
Bestimmen durch die Master-Steuereinheit, einer gesamten Betriebsleistungsgrenze und einer gesamten Lade- oder Entladeleistung durch Summieren der Betriebsleistungsgrenzen und der Lade- oder Entladeleistung, welche von den ersten bis n-ten Slave-Steuereinheiten übertragen werden;
Bereitstellen, durch die Master-Steuereinheit, einer Betriebsstopp-Nachricht an die ersten bis n-ten Slave-Steuereinheiten in Reaktion darauf, dass eine erste Betriebsstopp-Bedingung erfüllt ist, in welcher die gesamte Lade- oder Entladeleistung größer als ein vorfestgelegter instabiler Leistungsbereich des PCS ist, und die gesamte Lade- oder Entladeleistung um einen ersten Schwellenwert größer als die Betriebsleistungsgrenze ist,
Bereitstellen, durch die Master-Steuereinheit, der Betriebsstopp-Nachricht an die ersten bis n-ten Slave-Steuereinheiten in Reaktion darauf, dass eine zweite Betriebsstopp-Bedingung erfüllt ist, in welcher die gesamte Lade- oder Entladeleistung innerhalb des vorfestgelegten instabilen Leistungsbereichs des PCS ist und die gesamte Ladeleistung oder Entladeleistung um einen zweiten Schwellenwert, welcher größer als der erste Schwellenwert ist, größer als die gesamte Betriebsleistungsgrenze ist; und
Stoppen, durch die ersten bis n-ten Slave-Steuereinheiten, des Betriebs des Batteriegestells, welches alleine angebracht ist, in Reaktion darauf, dass die Betriebsstopp-Nachricht empfangen wird.

## Revendications

1. Appareil (10) de gestion de source de stockage de puissance, comprenant :
une unité (15) de capteur configurée pour mesurer des caractéristiques de fonctionnement d'une source (11) de stockage de puissance ; et
une unité (16) de commande fonctionnellement couplée à l'unité de capteur,
dans lequel l'unité de commande est configurée pour :
(i) acquérir des informations de caractéristiques de fonctionnement de la source de stockage de puissance en provenance de l'unité de capteur et déterminer une limite de puissance de fonctionnement de la source de stockage de puissance,
(ii) déterminer une puissance de charge fournie par un système (13) de conversion de puissance, PCS, ou
une puissance de décharge fournie au PCS à l'aide des informations de caractéristiques de fonctionnement pendant le fonctionnement de la source de stockage de puissance,
(iii) arrêter le fonctionnement de la source de stockage de puissance en réponse à une première condition d'arrêt de fonctionnement qui est remplie dans laquelle la puissance de charge ou la puissance de décharge est supérieure à une plage de puissance instable prédéfinie du PCS, et la puissance de charge ou la puissance de décharge est supérieure à la limite de puissance de fonctionnement d'un premier seuil, et
(iv) arrêter le fonctionnement de la source de stockage de puissance en réponse à une seconde condition d'arrêt de fonctionnement qui est remplie dans laquelle la puissance de charge ou la puissance de décharge se situe dans la plage de puissance instable prédéfinie du PCS, et la puissance de charge ou la puissance de décharge est supérieure à la limite de puissance de fonctionnement d'un second seuil supérieur au premier seuil.

2. Appareil de gestion de source de stockage de puissance selon la revendication 1, dans lequel l'unité de commande est configurée pour recevoir les informations de caractéristiques de fonctionnement incluant un courant de charge/décharge, une tension et une température de la source de stockage de puissance en provenance de l'unité de capteur, déterminer un état de charge, SOC, de la source (11) de stockage de puissance par accumulation du courant de charge/décharge, et déterminer la limite de puissance de fonctionnement de la source de stockage de puissance correspondant au SOC déterminé et à la température reçue en se référant à des informations de recherche définissant une corrélation entre le SOC et la température et la limite de puissance de fonctionnement.

3. Appareil de gestion de source de stockage de puissance selon la revendication 1, dans lequel l'unité (16) de commande reçoit des informations associées à la plage de puissance instable prédéfinie du PCS en provenance du PCS.

4. Appareil de gestion de source de stockage de puissance selon la revendication 1, dans lequel le premier seuil est de 10 % à 30 % de la limite de puissance de fonctionnement.

5. Appareil de gestion de source de stockage de puissance selon la revendication 1, dans lequel le second seuil est de 30 % à 60 % de la limite de puissance de fonctionnement.

6. Appareil de gestion de source de stockage de puissance selon la revendication 5, dans lequel le second seuil augmente à mesure que la puissance de charge ou la puissance de décharge de la source de stockage de puissance diminue.

7. Appareil de gestion de source de stockage de puissance selon la revendication 1, dans lequel la source de stockage de puissance inclut des premier à n^{e} supports de batterie.

8. Appareil (10) de gestion de source de stockage de puissance, comprenant :
les première à n^{e} unités (16-1 - 16-n) de commande esclaves respectivement montées dans les premier à n^{e} supports (11-1 - 11-n) de batterie ; et
une unité (21) de commande maître couplée aux première à n^{e} unités de commande esclaves pour permettre une communication entre elles,
dans lequel chacune des première à n^{e} unités de commande esclaves est configurée pour acquérir des informations de caractéristiques de fonctionnement du support de batterie monté seul en provenance d'une unité (15-1 - 15-n) de capteur, déterminer une limite de puissance de fonctionnement et une puissance de charge ou de décharge du support de batterie à l'aide des informations de caractéristiques de fonctionnement et fournir ces dernières à l'unité de commande maître, et
dans lequel l'unité de commande maître est configurée pour :
déterminer une limite de puissance de fonctionnement totale et une puissance de charge ou de décharge totale en additionnant les limites de puissance de fonctionnement et la puissance de charge ou de décharge transmise par les première à n^{e} unités de commande esclaves,
fournir un message d'arrêt de fonctionnement aux première à n^{e} unités de commande esclaves en réponse à une première condition d'arrêt de fonctionnement qui est remplie dans laquelle la puissance totale de charge ou de décharge est supérieure à une plage de puissance instable prédéfinie d'un système de conversion de puissance, PCS,
et la puissance de charge ou de décharge totale est supérieure à la limite de puissance de fonctionnement totale d'un premier seuil, et
fournir le message d'arrêt de fonctionnement aux première à n^{e} unités de commande esclaves en réponse à une seconde condition d'arrêt de fonctionnement qui est remplie dans laquelle la puissance totale de charge ou de décharge se situe dans la plage de puissance instable prédéfinie du PCS et la puissance totale de charge ou de décharge est supérieure à la limite de puissance totale de fonctionnement d'un second seuil supérieur au premier seuil.

9. Procédé de commande d'un appareil (10) de gestion de source de stockage de puissance, comprenant :
l'acquisition d'informations de caractéristiques de fonctionnement d'une source (11) de stockage de puissance en provenance d'une unité (15) de capteur qui mesure des caractéristiques de fonctionnement de la source de stockage de puissance ;
la détermination d'une limite de puissance de fonctionnement de la source de stockage de puissance à l'aide des informations de caractéristiques de fonctionnement ;
la détermination d'une puissance de charge fournie en provenance d'un système de conversion de puissance, PCS, ou d'une
puissance de décharge fournie au PCS à l'aide des informations de caractéristiques de fonctionnement pendant le fonctionnement de la source de stockage de puissance ;
l'arrêt du fonctionnement de la source de stockage de puissance en réponse à une première condition d'arrêt de fonctionnement qui est remplie dans laquelle la puissance de charge ou de décharge est supérieure à une plage de puissance instable prédéfinie du PCS, et la puissance de charge ou de décharge est supérieure à la limite de puissance de fonctionnement d'un premier seuil ; et
l'arrêt du fonctionnement de la source de stockage de puissance en réponse à une seconde condition d'arrêt de fonctionnement qui est remplie dans laquelle la puissance de charge ou la puissance de décharge est dans la plage de puissance instable prédéfinie du PCS, et la puissance de charge ou la puissance de décharge est supérieure à la limite de puissance de fonctionnement d'un second seuil supérieur au premier seuil.

10. Procédé de commande d'un appareil de gestion de source de stockage de puissance selon la revendication 9, dans lequel le procédé comprend :
la réception des informations de caractéristiques de fonctionnement incluant un courant de charge/décharge, une tension et une température de la source de stockage de puissance de l'unité de capteur ;
la détermination d'un état de charge, SOC, de la source de stockage de puissance par accumulation du courant de charge/décharge ; et
la détermination de la limite de puissance de fonctionnement de la source de stockage de puissance correspondant au SOC déterminé et à la température reçue en se référant à des informations de recherche définissant une corrélation entre le SOC et la température et la limite de puissance de fonctionnement.

11. Procédé de commande d'un appareil de gestion de source de stockage de puissance selon la revendication 9, comprenant en outre :
la réception d'informations associées à la plage de puissance instable prédéfinie du PCS en provenance du PCS.

12. Procédé de commande d'un appareil de gestion de source de stockage de puissance selon la revendication 9, dans lequel le premier seuil est de 10 % à 30 % de la limite de puissance de fonctionnement.

13. Procédé de commande d'un appareil de gestion de source de stockage de puissance selon la revendication 9, dans lequel le second seuil est de 30 % à 60 % de la limite de puissance de fonctionnement.

14. Procédé de commande d'un appareil de gestion de source de stockage de puissance selon la revendication 13, dans lequel le second seuil augmente à mesure que la puissance de charge ou de décharge de la source de stockage de puissance diminue.

15. Procédé de commande d'un appareil (10) de gestion d'énergie de stockage de puissance,
l'appareil de gestion de source de stockage de puissance incluant des première à n^{e} unités (16-1 - 16-n) de commande esclaves respectivement montées dans des premier à n^{e} supports (11-1 - 11-n) de batterie et une unité (21) de commande maître couplée aux première à n^{e} unités de commande esclaves pour permettre une communication entre elles, le procédé comprenant :
l'acquisition, par chacune des première à n^{e} unités de commande esclaves, d'informations de caractéristiques de fonctionnement en provenance d'une unité (15-1 - 15-n) de capteur qui mesure des caractéristiques de fonctionnement du support de batterie monté seul, la détermination d'une limite de puissance de fonctionnement et d'une puissance de charge ou de décharge du support de batterie et la fourniture de ces dernières à l'unité de commande maître ;
la détermination, par l'unité de commande maître, d'une limite de puissance de fonctionnement totale et d'une puissance de charge ou de décharge totale en additionnant les limites de puissance de fonctionnement et la puissance de charge ou de décharge transmises par les première à n^{e} unités de commande esclaves ;
la fourniture, par l'unité de commande maître, d'un message d'arrêt de fonctionnement aux première à n^{e} unités de commande esclaves en réponse à une première condition d'arrêt de fonctionnement qui est remplie dans laquelle la puissance de charge ou de décharge totale est supérieure à une plage de puissance instable prédéfinie du PCS, et la puissance de charge ou de décharge totale est supérieure à la limite de puissance de fonctionnement totale d'un premier seuil ;
la fourniture, par l'unité de commande maître, du message d'arrêt de fonctionnement aux première à n^{e} unités de commande esclaves en réponse à une seconde condition d'arrêt de fonctionnement qui est remplie dans laquelle la puissance totale de charge ou de décharge se situe dans la plage de puissance instable prédéfinie du PCS, et la puissance totale de charge ou de décharge est supérieure à la limite de puissance de fonctionnement totale d'un second seuil supérieur au premier seuil ; et
l'arrêt, par les première à n^{e} unités de commande esclaves, du fonctionnement du support de batterie monté seul en réponse à la réception du message d'arrêt de fonctionnement.
